# FASCICULE DE BREVET EUROPEEN

(11) **EP 0 407 787 B1**
(45) Date de publication et mention de la délivrance du brevet: **13.10.1993**
(21) Numéro de dépôt: 90111862.0
(22) Date de dépôt: 22.06.1990
(51) Int. Cl.: G01R 31/318

(54) **Agencement de test de cartes à circuit imprimé et son application au test de cartes à circuit imprimé formant un équipement de multiplexage-démultiplexage de signaux numériques**
Testvorrichtung für gedruckte Schaltungskarten und ihre Anwendung für das Testen von gedruckten Schaltungskarten, in Form einer Multiplex-Demultiplexeinrichtung für numerische Signale
Test device for printed circuit cards and its application for testing printed circuit boards, forming a multiplexer-demultiplexer arrangement for numerical signals

(30) Priorité: 27.06.1989 FR 8908562
(43) Date de publication de la demande: 16.01.1991
(73) Titulaire: ALCATEL CIT, 75008 Paris (FR)
(72) Inventeur: Beaufils, Jean-Marie, F-75014 Paris (FR); Marot, Jean-Loup, F- 91290 Arpajon (FR)
(74) Mandataire: Weinmiller, Jürgen

(56) Documents cités:
- DE-A- 2 738 833
- IBM TECHNICAL DISCLOSURE BULLETIN, vol. 31, no. 2, juillet 1988, pages 144-147, New York, US; "Card testing in target systems"
- IBM TECHNICAL DISCLOSURE BULLETIN, vol. 31, no. 1, juin 1988, pages 215-216, New York, US; "Debug method for logic card"
- IBM TECHNICAL DISCLOSURE BULLETIN, vol. 15, no. 5, octobre 1972, pages 1439-1440, New York, US; S.J. IPPOLITO et al.: "On site card tester"

## Description

La présente invention concerne un agencement de test de cartes à circuit imprimé comportant une carte à circuit imprimé, dite carte de test, apte à être connectée à une carte à circuit imprimé à tester. L'invention est particulièrement applicable au cas de cartes assemblées dans une même structure mécanique pour former un équipement fonctionnel complexe, par exemple un équipement de transmission tel qu'un équipement de multiplexage-démultiplexage numérique.

La mise en service ou la maintenance de tels équipements exige de tester le bon fonctionnement des cartes élémentaires qui les composent. La réalisation de ces tests nécessite un accès aux différents points d'une carte concernés par le test pour pouvoir soit y injecter le signal souhaité, soit recueillir le signal à observer, ces points et signaux étant variables suivant le type d'équipement et suivant le type de test. Les techniques utilisées couramment à cette fin nécesssitent généralement une interruption des signaux normalement traités par la carte à tester pour les remplacer par des signaux de test et consistent à prévoir sur ces cartes des accès spécifiques qui sont soit localisés directement sur la face avant des cartes à tester, soit regroupés sur des élements appelés généralement panneaux de raccordement, auxquels est affecté un emplacement particulier dans l'équipement.

Avec la compacité croissante des équipements , il devient cependant de plus en plus difficile d'utiliser de telles techniques.

La présente invention a pour objet un agencement de test permettant d'apporter une solution à ce problème.

Le document IBM Technical Disclosure Bulletin, Vol. 31, n° 1, juin 1988, page 215-216, New York, US "Debug method for logic card", décrit un agencement similaire à celui du préambule de la revendication 1.

La présente invention a également pour objet un agencement de test permettant de réduire le taux d'intervention de l'opérateur nécessaire à l'exécution de ces tests, cette intervention se limitant en effet, avec un agencement suivant l'invention, à des commandes, et ne nécessitant plus d'interventions manuelles pour effectuer des opérations telles que connexions, ruptures de connexions, etc..., pour remplacer les signaux normalement traités par la carte par des signaux de test.

Selon l'invention, l'agencement de test de carte à circuit imprimé comportant une carte à circuit imprimé, dite carte de test, apte à être connectée à une carte à circuit imprimé à tester, est essentiellement caractérisé en ce que l'une au moins de ces deux cartes est équipée de circuits de sélection de type de signaux traités par la carte à tester, lesdits circuits de sélection étant aptes à placer au moins un sous ensemble de la carte à tester soit en configuration de test, soit en configuration normale, et en ce que la carte de test est munie d'accès de commande de configuration et équipée de circuits de raccordement de ces accès aux dits circuits de sélection.

D'autres objets et caractéristiques de la présente invention apparaîtront plus clairement à la lecture de la description suivante d'exemples de réalisation, faite en relation avec les dessins ci-annexés dans lesquels :
- la figure 1 est une vue en perspective d'une carte à tester
- la figure 2 est une vue en perspective de la carte à tester et de la carte de test.
- la figure 3 est un exemple de schéma électrique d'une carte à tester
- la figure 4 est un exemple de schéma électrique de la carte de test.
- la figure 5 rappelle la constitution d'un équipement de multiplexage-démultiplexage de signaux numériques.

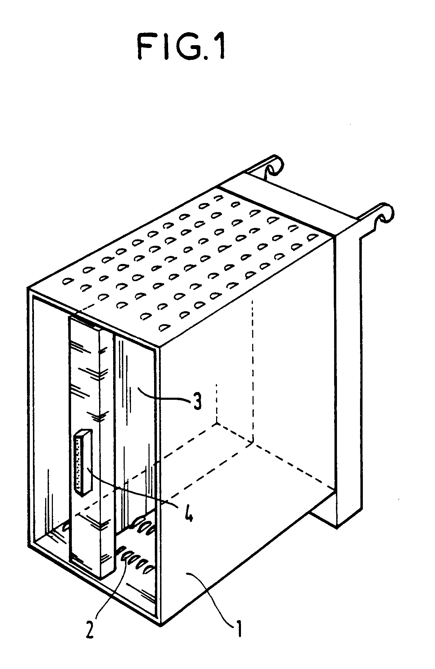

Sur la figure 1 est représenté suivant une vue en perspective un coffret 1, couramment appelé châssis, ou bac, muni de glissières 2 dans lesquelles peuvent être montées des cartes à circuit imprimé, dites cartes d'équipement, dont une, référencée 3, est représentée sur cette figure, le circuit électrique qu'elle comporte n'étant toutefois pas illustré pour ne pas surcharger la figure.

Cette carte, qui constitue la carte à tester, est munie sur sa face avant d'un demi connecteur multipoints 4, procurant un accès aux différents points de la carte concernés par les opérations de test.

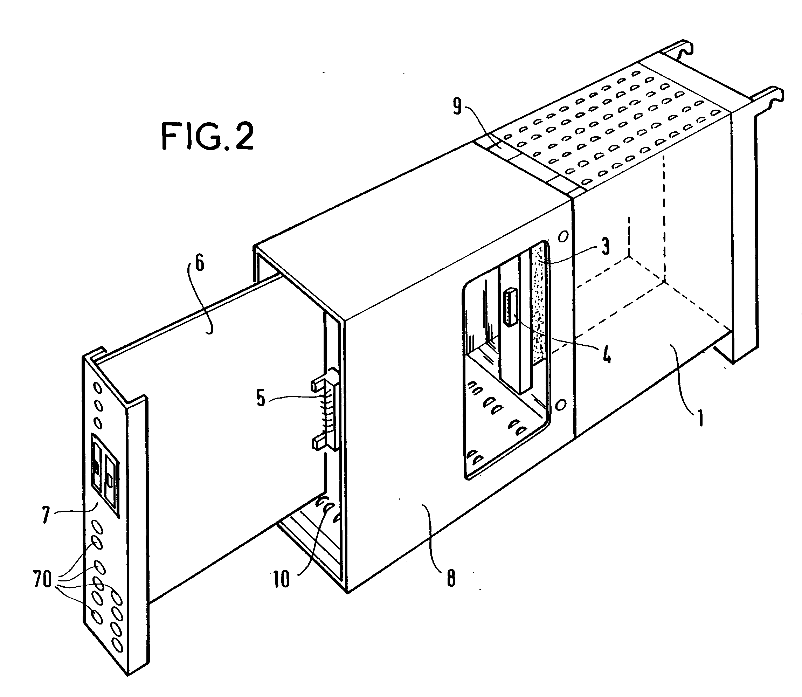

Dans la figure 2, on a représenté, outre le bac 1 avec la carte d'équipement 3 munie du demi-connecteur 4, une carte 6, dite carte de test, à laquelle est destinée à être raccordée la carte d'équipement 3 pour être testée. La carte de test 6, dont le circuit électrique qu'elle comporte n'a pas non plus été représenté, est équipée sur sa face arrière d'un demi connecteur multipoints 5 complémentaire du demi-connecteur 4. La carte 6 est munie sur sa face avant de boutons de commande, de prises permettant de recevoir des signaux extérieurs, et de voyants lumineux, tous ces éléments d'interface avec l'extérieur, référencés 70, étant regroupés sur un panneau 7 mécaniquement solidaire de cette carte et connecté électriquement à la masse de celle-ci.

Pour une meilleure stabilité mécanique de l'ensemble carte à tester- carte de test assemblé par l'intermédiaire des deux demi- connecteurs 4 et 5, un bac prolongateur 8 peut être fixé au bac 1 par des moyens de fixation tels que 9, avant assemblage de ces deux cartes au moyen des demi-connecteurs 4 et 5. Ce bac prolongateur est également muni de glissières 10 dans lesquelles la carte de test peut ensuite être montée, en vis à vis de la carte à tester, puis raccordée à celle-ci comme on l'a vu au moyen des demi-connecteurs 4 et 5.

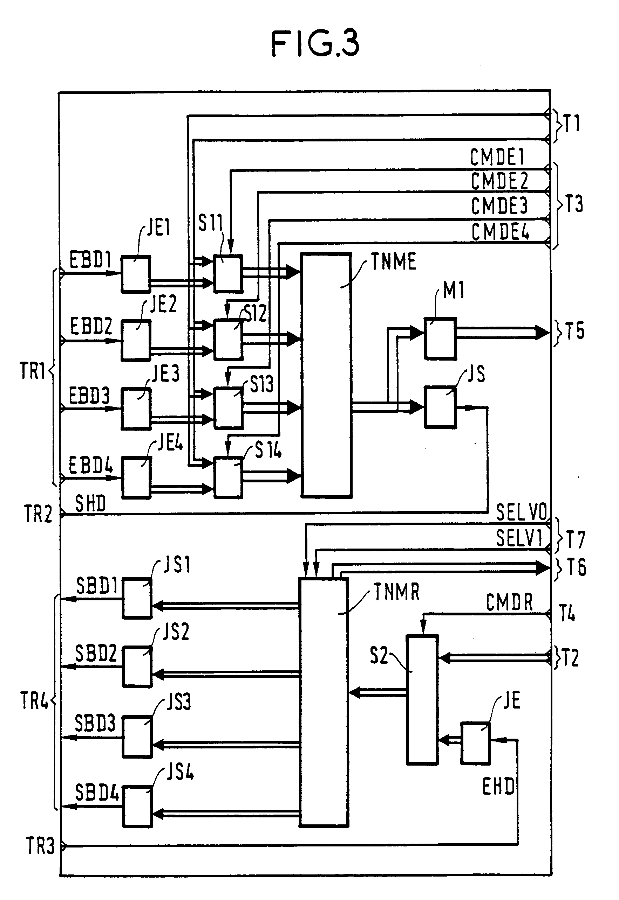

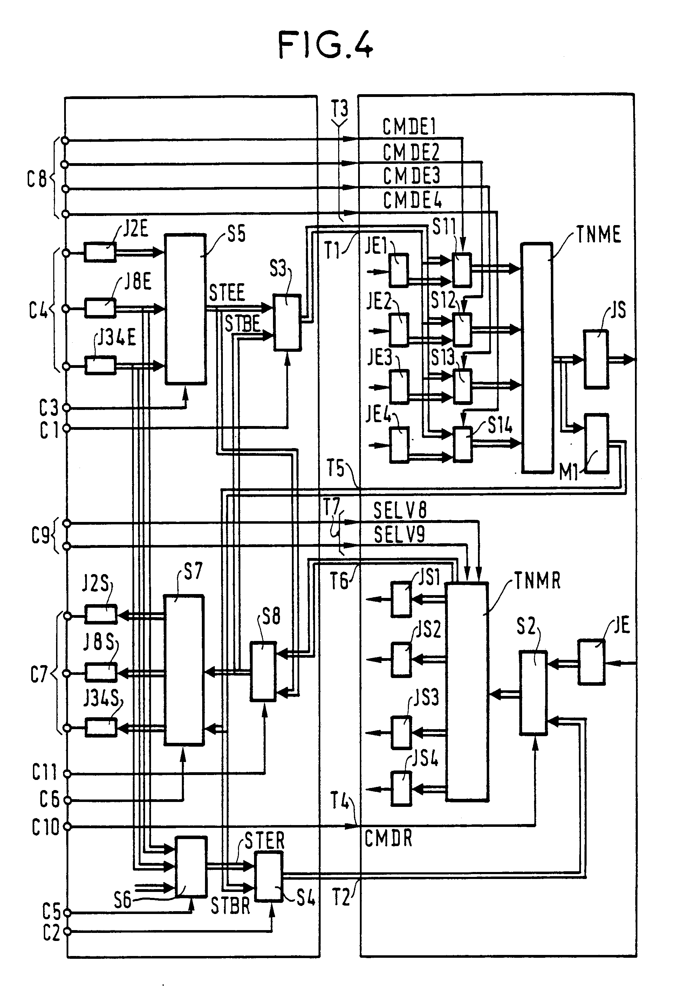

On décrit maintenant, en relation avec la figure 3, un exemple d'aménagements apportés au schéma électrique d'une carte d'équipement pour lui permettre de coopérer avec une carte de test dans un agencement suivant l'invention, le schéma électrique de cette carte de test étant ensuite décrit en relation avec la figure 4.

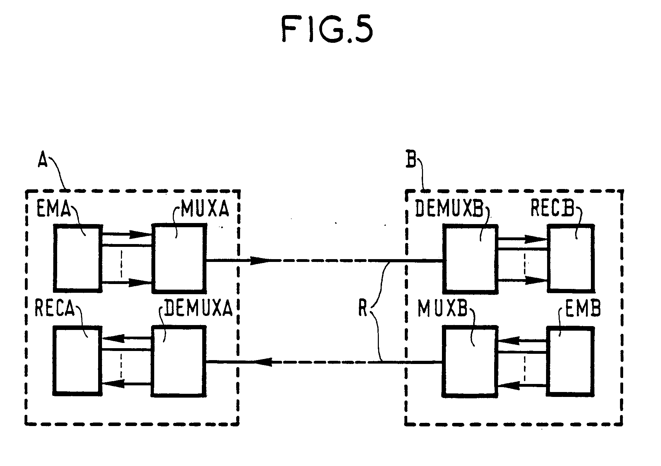

A titre d'exemple on considérera maintenant le cas d'un équipement de transmission constitué, comme représenté schématiquement sur la figure 5, par un ensemble multiplexeur-démultiplexeur équipant une station telle que A connectée par un réseau de transmission R à une autre station telle que B également équipée d'un tel ensemble multiplexeur-démultiplexeur, les multiplexeurs MUXA et MUXB de ces stations étant par ailleurs connectés, en fonctionnement normal, chacun à un équipement d'émission, respectivement EMA et EMB, et les démultiplexeurs DEMUXA et DEMUXB de ces stations étant de même connectés chacun à un équipement de réception, respectivement RECA et RECB.

La compacité des matériels les plus récents est telle qu'un ensemble multiplexeur- démultiplexeur d'une station, tel que MUXA-DEMUXA, peut loger sur une seule carte d'équipement dont les accès au réseau de transmission d'une part et aux équipements d'émission et de réception d'autre part forment une première série d'accès à cette carte, dit accès de trafic, localisés sur sa face arrière et n'ayant pas à être modifiés au cours des opérations de test de cette carte effectuées au moyen de l'agencement suivant l'invention, ce qui constitue un des avantages de cet agencement.

Une deuxième série d'accès à cette carte d'équipement, dits accès de test, est formée par les accès au demi-connecteur multipoints localisé sur la face avant de cette carte (connecteur référencé 4 sur les figures 1 et 2).

Les accès de trafic comportent des accès TR1 sur lesquels sont appliqués les signaux de trafic d'entrée du multiplexeur , en l'occurrence quatre entrées sur lesquelles sont respectivement appliqués quatre signaux bas débit EBD1 à EBD4 dans l'exemple représenté sur la figure 3, un accès TR2 sur lequel est obtenu le signal de trafic de sortie haut débit SHD du multiplexeur, un accès TR3 sur lequel est appliqué le signal de trafic d'entrée haut débit EHD du démultiplexeur, et des accès TR4 sur lesquels sont obtenus les signaux de trafic de sortie bas débit de ce démultiplexeur, en l'occurence quatre sorties sur lesquelles sont respectivement obtenus quatre signaux bas débit SBD1 à SBD4.

Une carte de circuit imprimé multiplexeur-démultiplexeur comporte de façon connue un circuit intégré, référencé TNME, réalisant la fonction de multiplexage proprement dite, recevant les signaux de trafic d'entrée bas débit EBD1-EBD4, par l'intermédiaire de circuits JE1-JE4 dits jonctions d'entrée bas débit et ayant une fonction d'interface, et fournissant le signal de trafic de sortie haut débit SHD, par l'intermédiaire d'un circuit JS dit jonction de sortie haut débit, et ayant également une fonction d'interface.

Cette carte de circuit imprimé multiplexeur-démultiplexeur comporte également un circuit intégré, référencé TNMR, réalisant la fonction de démultiplexage proprement dite , recevant en entrée le signal de trafic d'entrée haut débit EHD, par l'intermédiaire d'un circuit JE dit jonction d'entrée haut débit et ayant une fonction d'interface, et fournissant les signaux de trafic de sortie bas débit SBD1 - SBD4 par l'intermédiaire de circuits JS1-JS4 dits jonctions de sortie bas débit et ayant également une fonction d'interface.

Suivant l'invention les entrées du circuit intégré multiplexeur TNME ne sont pas connectées aux sorties des jonctions d'entrée bas débit JE1-JE4 directement, mais par l'intermédiaire d'un organe de sélection, respectivement S11- S14, permettant de sélectionner soit les signaux de trafic, soit des signaux de test injectés sur des accès de test T1 de la carte d'équipement.

De même les entrées du circuit intégré démultiplexeur TNMR ne sont pas connectées aux sorties de la jonction d'entrée haut débit directement, mais par l'intermédiaire d'un organe de sélection S2, permettant de sélectionner soit le signal de trafic, soit un signal de test injecté sur des accès de test T2 de la carte d'équipement.

Dans l'exemple considéré, les signaux de sortie des jonctions d'entrée bas débit étant formés de deux signaux binaires représentant respectivement les impulsions positives et négatives d'un signal numérique codé suivant un code bipolaire, les signaux de test appliqués sur les accès T1 sont constitués de la même façon et formés de deux signaux binaires.

De même, les signaux de sortie d'une jonction d'entrée haut débit étant dans l'exemple considéré formés de quatre signaux binaires représentant respectivement les impulsions positives et négatives d'un signal numérique codé suivant un code bipolaire, le signal d'horloge et un signal d'alarme indiquant une perte de signal reçu, les signaux de test appliqués sur les accès de test T2 sont constitués de la même façon et formés de quatre signaux binaires. Des accès detest T3 et T4 sont par ailleurs prévus pour recevoir des signaux de commande des organes de sélection, respectivement S11-S14 et S2.

Dans l'exemple considéré le circuit intégré multiplexeur TNME ayant quatre entrées bas débit, et les organes de sélection S11-S14 étant eux-mêmes au nombre de quatre, les signaux binaires de commande de sélection appliqués sur les accès de test T3 sont au nombre de quatre , référencés CMDE1-CMDE4.

L'organe de sélection S2 d'entrée haut débit du démultiplexeur est quant à lui commandé par un signal binaire CMDR appliqué sur l'accès de test T4 et permettant de sélectionner soit le signal de trafic haut débit soit le signal de test haut débit.

La carte d'équipement de multiplexage-démultiplexage représentée sur la figure 3 est par ailleurs munie de moyens de duplication des signaux de sortie du circuit intégré multiplexeur TNME et du circuit intégré demultiplexeur TNMR, en vue d'obtenir les signaux ainsi dupliqués sur des accès de test de cette carte référencés T5 pour le multiplexeur et T6 pour le démultiplexeur.

Dans l'exemple considéré, les signaux obtenus sur les accès T5 sont obtenus en sortie d'un élément de mémorisation M1 recevant lui-même lesdits signaux du multiplexeur TNME, les signaux obtenus sur les accès T6 étant directement obtenus en sortie du démultiplexeur TNMR incluant un élément de mémorisation M2 analogue à M1.

Par ailleurs sont prévus des accès de test T7 pour la sélection d'une parmi quatre des sorties bas débit du démultiplexeur à dupliquer, sur lesquels sont appliqués en l'occurence deux signaux SELV0 et SELV1, ensuite appliqués directement au démultiplexeur.

On décrit maintenant, en relation avec la figure 4, le schéma de la carte de test. Pour une meilleure compréhension de la façon dont cette carte coopère avec la carte d'équipement décrite ci-dessus, le schéma de cette dernière a été repris sur cette figure.

Cette carte de test est munie d'une première série d'accès correspondant aux accès de test de la carte d'équipement et formés par les accès au demi-connecteur multipoints localisé sur la face arrière de cette carte ( référencé 5 sur la figure 1), et d'une deuxième série d'accès, dits accès de commande, correspondant aux accès au panneau d'interface avec l'extérieur (référencé 7 sur la figure 2) équipant la face avant de la carte de test.

Cette carte de test comporte des moyens de sélection de signaux de test à appliquer à la carte multiplexeur-démultiplexeur. Ces moyens de sélection de signaux de test comportent , associé au multiplexeur TNME, un organe de sélection S3 commandé par les signaux appliqués à des accès de commande C1 de la carte de test, et permettant d'appliquer aux accès de test T1 de la carte multiplexeur-démultiplexeur soit un signal de test extérieur, référencé STEE, soit un signal de test de bouclage, référencé STBE, et de même, associé au démultiplexeur TNMR, un organe de sélection S4 commandé par les signaux appliqués à des accès de commande C2 de la carte de test, et permettant d'appliquer aux accès de test T2 de la carte d'équipement à tester soit un signal de test extérieur, référencé STER, soit un signal de test de bouclage, référencé STBR.

Cette carte de test étant prévue pour tester des cartes multiplexeurs-démultiplexeurs pouvant fonctionner à différents débits, le signal de test extérieur STEE appliqué à l'organe de sélection S3 est lui-même obtenu en sortie d'un organe de sélection qui peut recevoir en entrée plusieurs signaux de test possibles correspondant à différents débits possibles et issus par exemple d'un générateur de signaux de test connectable au panneau d'interface avec l'extérieur équipant cette carte.

En l'occurence on a considéré trois signaux correspondant à trois débits différents : 2Mbit/s, 8Mbit/s, et 34 Mbit/s. Ces signaux sont des signaux binaires qui sont appliqués à l'organe de sélection S5 après passage dans des jonctions d'entrée J2E, J8E et J34E correspondant respectivement à ces différents débits et ayant une fonction d'interface analogue à celle des jonctions d'entrée bas débit JE1-JE4, ou haut débit, JE, équipant la carte multiplexeur- démultiplexeur. Les entrées de ces jonctions d'entrée J2E, J8E, J34E forment des accès de commande C4 de la carte de test.

De même le signal de test extérieur STER appliqué à l'organe de sélection S4 est obtenu en sortie d'un organe de sélection S6 qui reçoit en entrée les signaux de sortie des jonctions d'entrée J8E et J34E et qui est commandé par les signaux appliqués à des accès de commande C5 de la carte de test.

La façon dont sont obtenus les signaux de test dè bouclage STBE et STBR apparaîtra à la lecture de la description suivante de la carte de test.

Cette carte de test comporte en outre des moyens de sélection permettant de sélectionner différents débits de signaux à observer en sortie de la carte multiplexeur-démultiplexeur. Ces moyens de sélection de différents débits de signaux à observer comportent un organe de sélection S7 commandé par des signaux appliqués sur des accès de commande C6 de la carte de test, et permettant d'aiguiller les signaux disponibles sur les accès de test T6, c'est-à-dire les signaux disponibles sur la sortie du circuit intégré démultiplexeur sélectionnée par les signaux appliqués sur les accès de test T7, ainsi que les signaux disponibles sur la sortie du circuit intégré multiplexeur vers deux des trois jonctions de sortie J2S, J8S, J34S sélectionnées en fonction des débits correspondant à la carte multiplexeur-démultiplexeur testée , soit en l'occurence, 2 Mbit/s et 8 Mbit/s, ou 8 Mbit/s et 34/Mbit/s, ces jonctions de sortie ayant une fonction d'interface analogue à celle des jonctions de sortie haut débit JS ou bas débit JS1-JS4.

Les signaux de test de bouclage STBE et STBR sont formés par les signaux disponibles respectivement sur les accès de test T6 et T5.
Les sorties de ces jonctions de sortie J2S, J8S, J34S constituent des accès de commande C7 de la carte de test. La sortie de la jonction sélectionnée est connectée à un appareil de mesure par l'intermédiaire du panneau d'interface avec l'extérieur équipant cette carte.

Les accès de test T3, T7 et T4 sont simplement prolongés à travers la carte de test pour former des accès de commande C8, C9 et C10 de cette carte.

L'application d'un signal de test à l'une des entrées bas débit du circuit intégré multiplexeur nécessite alors les opérations suivantes :
- sélection de l'entrée bas débit considérée du circuit intégré multiplexeur, par application de signaux de commande CMDE1-CMDE4 adéquats sur les accès de commande C8.
- sélection du type de signal de test à appliquer : signal de test extérieur, ou signal de test de bouclage, par application de signaux de commande adéquats sur les accès de commande C1.
- si le signal de test à appliquer est un signal de test extérieur, connexion d'un générateur de signal de test à l'entrée de l'une des jonctions d'entrée J2E, J8E, sélectionnée, en fonction de la carte multiplexeur-démultiplexeur à tester, par application de signaux adéquats sur les accès de commande C3.
- si le signal de test à appliquer est un signal de test de bouclage, sélection, par les accès de commande C9, de la sortie du circuit intégré démultiplexeur qui est à boucler sur l'entrée considérée du circuit intégré multiplexeur.

De même l'application d'un signal de test à l'entrée haut débit du circuit intégré démultiplexeur nécessite les opérations suivantes :
- application de signaux adéquats sur les accès de commande C10 pour aiguiller vers l'entrée du démultiplexeur des signaux de test et non de trafic.
- application de signaux adéquats sur les accès de commande C2 afin d'aiguiller vers l'entrée haut débit du démultiplexeur soit un signal de test extérieur soit un signal de test de bouclage.
- si le signal de test à appliquer est un signal de test extérieur, connexion d'un générateur de signal de test à l'entrée de l'une des jonctions J8E, J34E, sélectionnée, en fonction de la carte multiplexeur-démultiplexeur à tester, par application de signaux adéquats sur les accès de commande C5.

L'observation des signaux de sortie bas débit obtenus sur l'une des sorties du circuit intégré démultiplexeur nécessite les opérations suivantes :
- application de signaux adéquats aux accès de commande C9, pour sélectionner la sortie bas débit considérée du circuit intégré démultiplexeur.
- application de signaux adéquats sur les accès de commande C6 de l'organe de sélection S7 pour raccorder celle des jonctions de sortie J2S, J8S, correspondant au débit souhaité à la sortie dupliquée du circuit intégré démultiplexeur.
- connexion d'un appareil de mesure en sortie de celle des jonctions de sortie J2S, J8S ainsi raccordée à cette sortie bas débit dupliquée.

L'observation des signaux de sortie haut débit obtenus en sortie du circuit intégré multiplexeur nécessite les opérations suivantes :
- application de signaux adéquats sur les accès de commande C6 de l'organe de sélection S7 pour raccorder celle des jonctions de sortie J8S, J34S, correspondant au débit souhaité à la sortie haut débit dupliquée du circuit intégré multiplexeur.
- connexion d'un appareil de mesure en sortie de celle des jonctions de sortie J8S,J34S ainsi raccordée à cette sortie haut débit dupliquée.

Il est possible d'effectuer en même temps l'observation des signaux de sortie bas débit obtenus sur l'une des sorties du circuit intégré démultiplexeur et celle des signaux de sortie haut débit obtenus en sortie du circuit intégré multiplexeur, l'organe de sélection S7 permettant de raccorder ses deux entrées à deux quelconques de ses sorties.

L'agencement de test ainsi décrit permet donc d'observer le signal résultant après multiplexage, et/ou l'un des signaux composants après démultiplexage, d'une part en configuration normale de fonctionnement de la carte d'équipment et, d'autre part, dans les configurations de test suivantes :
a: bouclage de l'une des sorties bas débit du circuit intégré démultiplexeur sur l'une des entrées bas débit du circuit intégré multiplexeur.
b:bouclage de la sortie haut débit du circuit intégré multiplexeur sur l'entrée haut débit du circuit intégré démultiplexeur.
c: injection d'un signal de test à la place de l'un des signaux d'entrée bas débit du circuit intégré multiplexeur.
d: injection d'un signal de test à la place du signal d'entrée haut débit du circuit intégré démultiplexeur.

Il est également possible de combiner les configurations b et c d'une part, a et d d'autre part, ainsi que l'une des configurations b et d avec une configuration normale de l'équipement multiplexeur et l'une des configurations a et c avec une configuration normale de l'équipement démultiplexeur.

Il est par ailleurs possible de réaliser un test de la carte de test elle-même, par bouclage de la sortie de l'organe de sélection S5 sur une entrée de l'organe de sélection S7. Le signal d'entrée de cet organe de sélection S7 est alors obtenu en sortie d'un organe de sélection S8 de premières entrées reliées aux sorties S5 et de secondes entrées reliées à l'une des sorties dupliquées, par exemple à celles du circuit intégré démultiplexeur comme représenté sur la figure 4, et d'entrées de commande constituant des accès de commande C11 de la carte de test.

La commande des organes de sélection est telle que, pour un équipement de multiplexage-démultiplexage 2Mbit/s-8Mbit/s par exemple, l'entrée de l'organe de sélection S5 sélectionné est celle connectée à la sortie de la jonction d'entrée J2E et la sortie de l'organe de sélection S7 sélectionnée pour son raccordement à la sortie dupliquée du circuit intégré multiplexeur est celle connectée à l'entrée de la jonction de sortie J8S tandis que la sortie de l'organe de sélection S7 sélectionnée pour son raccordement à la sortie dupliquée du circuit intégré démultiplexeur est celle connectée à l'entrée de la jonction J2S.

De multiples variantes de réalisation pourraient être apportées aux cartes d'équipement et de test décrites ci-dessus, ces variantes pouvant concerner notamment :
- les débits définissant les cartes d'équipement à tester, le cas d'équipements de multiplexage-démultiplexage 34Mbit/s-140Mbit/s pouvant par exemple être prévu en supplément.
- la répartition des différents organes de sélection entre la carte d'équipement et la carte de test.
- la localisation des différents organes de sélection sur la carte de test par , exemple leur localisation en amont ou en aval des jonctions d'entrée et de sortie (avec sa conséquence sur le nombre et la localisation de ces jonctions sur ces cartes), ou encore leur plus ou moins grande intégration aux circuits intégrés multiplexeur et démultiplexeur.

Par ailleurs, le contenu de la carte de test et de la carte d'équipement pourraient évidemment être très différents dans le cas d'équipements autres qu'un équipement de multiplexage-démultiplexage de signaux numériques.

## Revendications

1. Agencement de test de carte à circuit imprimé, comportant une carte à circuit imprimé, dite carte de test, apte à être connectée à une carte à circuit imprimé à tester, caractérisé en ce que l'une au moins de ces deux cartes est équipée de circuits de sélection de type de signaux traités par la carte à tester, lesdits circuits de sélection étant aptes à placer au moins un sous-ensemble de la carte à tester soit en configuration de test, soit en configuration normale, et en ce que la carte de test est munie d'accès de commande de configuration et équipée de circuits de raccordement de ces accès auxdits circuits de sélection.

2. Agencement de test selon la revendication 1, caractérisé en ce que la carte à tester et la carte de test sont connectables par deux demi-connecteurs multipoints complémentaires l'un de l'autre équipant respectivement ces cartes.

3. Agencement de test selon l'une des revendications 1 et 2, caractérisé en ce que, les cartes à tester étant montées dans des coffrets, il comporte en outre un coffret prolongateur dans lequel est montée la carte de test avant sa connexion à la carte à tester, les deux coffrets étant assemblés par des moyens de fixation mécanique.

4. Application d'un agencement de test selon l'une des revendications 1 à 3, àu test de cartes à circuit imprimé formant un équipement de multiplexage-démultiplexage de signaux numériques, caractérisée en ce que lesdits circuits de sélection de types de signaux traités par la carte à tester sont aptes à placer le multiplexeur ou le démultiplexeur soit en configuration de test soit en configuration normale et en ce que l'une au moins des deux cartes, à tester et de test, comporte des circuits de sélection supplémentaires permettant d'appliquer à la carte à tester, en configuration de test du multiplexeur et / ou du démultiplexeur, soit un signal de test extérieur, soit un signal de test de bouclage issu du démultiplexeur pour le test du multiplexeur, ou du multiplexeur pour le test du démultiplexeur.

5. Application d'un agencement de test selon la revendication 4, caractérisée en ce que l'une au moins des deux cartes, à tester et de test, comporte des circuits de sélection supplémentaires permettant de sélectionner différents débits de signaux de test extérieurs à appliquer à la carte à tester, ou différents débits de signaux à observer en sortie de celle ci.

## Patentansprüche

1. Testeinrichtung für Druckschaltungskarten mit einer "Testkarte" benannten Druckschaltungskarte, die an eine zu testende Druckschaltungskarte angeschlossen werden kann, dadurch gekennzeichnet, daß mindestens eine der beiden Karten mit Auswahlkreisen zur Auswahl der durch die zu testende Karte behandelten Signaltypen versehen ist, wobei diese Auswahlkreise mindestens eine Untergruppe der zu testenden Karte entweder in eine Testkonfiguration oder in eine normale Konfiguration bringen können, und daß die Testkarte mit Konfigurationssteueranschlüssen versehen ist und Kreise zur Verbindung dieser Anschlüsse an die Auswahlkreise besitzt.

2. Testeinrichtung nach Anspruch 1, dadurch gekennzeichnet, daß die zu testende Karte und die Testkarte über zwei zueinander komplementäre Hälften einer Vielfachsteckverbindung verbunden werden können, die an je einer dieser Karten vorgesehen sind.

3. Testeinrichtung nach einem der Ansprüche 1 und 2, dadurch gekennzeichnet, daß die zu testenden Karten in Gehäusen untergebracht werden und die Einrichtung weiter ein Verlängerungsgehäuse enthält, in dem eine Testkarte vor ihrem Anschluß an die zu testende Karte montiert wird, wobei die beiden Gehäuse durch mechanische Mittel aneinander gekoppelt werden.

4. Anwendung einer Testeinrichtung nach einem der Ansprüche 1 bis 3 auf den Test von Druckschaltungskarten, die eine Multiplexier-Demultiplexiereinrichtung für digitale Signale bilden, dadurch gekennzeichnet, daß die Auswahlkreise für den Typ der von der zu testenden Karte behandelten Signale den Multiplexer oder den Demultiplexer entweder in Testkonfiguration oder in normale Konfiguration bringen können und daß mindestens eine der beiden Karten, nämlich die zu testende oder die Testkarte, zusätzliche Auswahlkreise besitzt, die an die zu testende Karte in der Testkonfiguration des Multiplexers und/oder des Demultiplexers entweder ein äußeres Testsignal oder ein Schleifentestsignal anlegen können, das aus dem Demultiplexer zum Test des Multiplexers oder aus dem Multiplexer zum Test des Demultiplexers stammt.

5. Anwendung einer Testeinrichtung nach Anspruch 4, dadurch gekennzeichnet, daß mindestens eine der beiden Karten, nämlich die zu testende oder die Testkarte, zusätzliche Auswahlkreise besitzt, um verschiedene an die zu testende Karte anzulegende äußere Testsignaldurchsätze oder verschiedene am Ausgang dieser Karte zu beachtende Signaldurchsätze auswählen zu können.

## Claims

1. Printed circuit board test system comprising a printed circuit board called test board, adapted to be connected to a printed circuit board to be tested, characterized in that at least one of these two boards is equipped with circuits for selecting the types of signal processed by the board to be tested, said selector circuits being adapted to place at least one subsystem on the board to be tested either in a test configuration or in a normal configuration, and that the test board is provided with configuration control ports and equipped with circuits for connecting these ports to said selector circuits.

2. Test system according to claim 1, characterized in that the board to be tested and the test board can be interconnected by two respective complementary multipin half-connectors.

3. Test system according to one of claims 1 and 2, characterized in that the boards to be tested are disposed in subracks and in that it further comprises an extension subrack in which the test board is mounted before it is connected to the board to be tested, the two subracks being assembled together by mechanical fixing means.

4. Application of a test system according to one of claims 1 to 3 to testing printed circuit boards forming a digital signal multiplex-demultiplex equipment, characterized in that said circuits for selecting the signal types processed by the board to be tested are adapted to place the multiplexer or the demultiplexer in a test configuration or in a normal configuration and in that at least one of the two boards (board to be tested and test board) comprises additional selector circuits for applying to the board to be tested in the test configuration of the multiplexer and/or the demultiplexer either an external test signal or a loopback test signal obtained from the demultiplexer for testing the multiplexer or from the multiplexer for testing the demultiplexer.

5. Application of a test system according to claim 4, characterized in that at least one of the two boards (board to be tested and test board) comprises additional selector circuits for selecting different bit rates of external test signals to be applied to the board to be tested or different bit rates of signals to be observed at the output of the latter.
